# EUROPEAN PATENT APPLICATION

(11) **EP 2 045 819 A1**
(43) Date of publication of application: **08.04.2009**
(21) Application number: 07117847.9
(22) Date of filing: 03.10.2007
(51) Int. Cl.: G21F 1/12, B01D 59/20

(54) **Neutron translucent construction material**

(71) Applicant: Nederlandse Organisatie voor Toegepast- Natuurwetenschappelijk Onderzoek TNO, 2628 VK Delft (NL)
(72) Inventor: Vroon, Zeger Alexander Eduarol Pieter, NL-6245 LB Eijsden (NL); Gubbels, Godefridus Hendricus Maria, NL-5704 AX Helmond (NL); Krosse, Sebeastiaan Maria, NL-5951 HB Belfeld (NL)
(74) Representative: Hatzmann, Martin

(57) **Abstract**

The invention is directed to a process for preparing a neutron translucent construction material, a neutron shielding construction material, a nuclear reactor comprising said neutron translucent construction material, and the use of said neutron translucent construction material.

The process of the invention comprises
a) providing at least one gas phase precursor;
b) enriching the at least one precursor in at least one isotope of an element contained in said precursor in a gas phase isotope separation step, wherein said at least one isotope has higher neutron translucency than another isotope of the same element; and
c) depositing the isotope enriched product of step b) on a substrate.

The construction material of the invention has a high degree of neutron translucency and can be used in the construction of nuclear reactors.

## Description

The invention is directed to a process for preparing a neutron translucent construction material, a neutron translucent construction material, a nuclear reactor comprising said neutron translucent construction material, and the use of said neutron shielding construction material.

Nuclear reactors are the containers in which nuclear reactions are performed. The energy released in most nuclear reactions is much larger than that in chemical reactions, because the binding energy that holds a nucleus together is far greater than the energy that holds electrons to a nucleus. Accordingly, nuclear reactions can be exploited in power plants for the provision of energy. The two most important nuclear reactions are nuclear fission and nuclear fusion. At present only nuclear fission is used in power plants to produce energy.

In a nuclear fission process neutrons are used to fission the nuclear fuel. The fission reaction produces not only energy and radiation but also additional neutrons. Thus a neutron chain reaction ensues. The nuclear reactor provides the assembly of materials to sustain and control the neutron chain reaction, to appropriately transport the heat produced from the fission reactions, and to provide the necessary safety features to cope with the radiation and radioactive materials produced by its operation.

Structural materials employed in fission reactor systems must possess suitable nuclear and physical properties and must be compatible with the reactor coolant under the conditions of operation.

Nuclear fusion is, at present, not used for generating energy in power plants. Nevertheless, research is being conducted with the goal of achieving controlled fusion and making fusion power a viable means of producing electricity. It is often claimed that nuclear fusion may provide clean, cheap and abundant energy. The expectation therefore is that nuclear fusion power plants will occupy at least part of the energy market in the future.

Nuclear fusion is the process by which two light atomic nuclei fuse together to form a heavier nucleus and thereby release energy. Most design studies for fusion power plants involve using the fusion reactions to create heat, which is then used to operate a steam turbine. Some of the most promising nuclear reactions (such as the deuterium-tritium fusion reaction and the deuterium-deuterium fusion reaction), however, involve the production of substantial amounts of neutrons that result in induced radioactivity within the reactor structure. The neutron flux expected in a commercial deuterium-tritium fusion reactor, for instance, is about 100 times that of current fission power reactors, thus posing unprecedented challenges for material design.

The conventional construction materials for nuclear reactors are based on naturally occurring elements. The most commonly employed structural materials in fission reactor systems are stainless steel and zirconium alloys. Zirconium alloys have favourable nuclear and physical properties, whereas stainless steel has favourable physical properties. Zirconium and stainless steel are used in high-temperature power reactors. Zirconium is relatively expensive, and its use is therefore confined to applications in the reactor core where neutron absorption is important.

Advantageously, the materials are made as elementally pure as possible. However, these conventional materials are typically sensitive to activation. In the context of this application the term "activation" is meant to refer to the process wherein a material is bombarded with neutrons, photons and/or electrons and forms an instable intermediate, which subsequently radioactively decays under the undesirable emission of ionising radiation. This decay is accompanied with a structural and mechanical degradation of the material.

Because the conventional construction materials are sensitive to activation, the nuclear reactors have limited lifetime and require regular maintenance. In addition, activation of the conventional construction materials results in the emission of radioactive alpha particles and often also helium gas is produced.

In view of the high demands for nuclear reactors, in particular for fusion reactors, there is a strong need for improved neutron translucent construction materials. The invention is directed at fulfilling this need.

Object of the invention is to provide a construction material having a high degree of physical and chemical stability against neutron bombardment. The construction material has to a high degree the properties of insensitivity and translucency for neutron bombardment.

A further object of the invention is to generally increase the lifetime of a nuclear reactor, in particular of the nuclear reactor wall.

A further object of the invention is to prolong the intervals between maintenance of a nuclear reactor so that nuclear power plants need to be shut down less often.

Yet a further object of the invention is to decrease the emission of alpha particles as a result of activation of construction material used in the nuclear reactor.

Surprisingly, it was found that these objects can at least partly be met by providing a construction material that is enriched in at least one specific isotope.

The inventors realised that not all isotopes of a specific element have the same stability under neutron bombardment. A material can be rendered more neutron bombardment stable when the material is enriched in one or more specific isotopes. This principle is employed in accordance with the invention for the preparation of neutron translucent construction material.

The term "neutron translucent" as used in this application is meant to refer to a high degree of physical, mechanical, structural and/or chemical stability of a material against neutron bombardment. A neutron translucent material is highly insensitive to neutron bombardment, in the sense that the material is activated by the neutrons only to a low degree.

Accordingly, in a first aspect the invention is directed to a process for preparing a neutron translucent construction material comprising
a) providing at least one gas phase precursor;
b) enriching the at least one precursor in at least one isotope of an element contained in said precursor in a gas phase isotope separation step, wherein said at least one isotope has higher neutron resistance than another isotope of the same element; and
c) depositing the isotope enriched product of step b) on a substrate.

The inventors found that this process allows a convenient and efficient fashion for preparing a construction material having high neutron bombardment stability. The high costs that are accompanied with isotope enrichment does not form a hurdle for the applications in which the invention can be implemented (such as the construction of a nuclear fusion reactor), because there is a lack of qualitatively good and cheap alternatives. Moreover, in accordance with the process of the invention costs can be saved by advantageously combining an isotope separation process with a deposition process.

Due to the high neutron translucency effect of the construction material of the invention, the material is not readily activated and thereby the structural and mechanical properties of the material are maintained for a significantly longer time than for comparable construction materials that are not enriched in one or more specific isotopes. In addition, the construction material of the invention is less prone to becoming radioactive. Besides giving rise to less radioactive waste, the material will therefore also enjoy better social acceptance.

The gas phase precursor provided can for instance comprise an element selected from the group consisting of C, Si, Ti, Li, W, Mo, Zr, Be, V, Cr, Cu, Ir, Ag, Dy, Hf and Ta. Precursors comprising such elements can give rise to construction materials with excellent structural and mechanical properties. Particularly preferred elements are C, Si and W.

The natural isotopes of carbon are ¹²C and ¹³C, where about 99 % of all naturally occurring carbon is ¹²C, while about 1 % of all naturally occurring carbon is ¹³C.

The natural isotopes of silicon are ²⁸Si, ²⁹Si, and ³⁰Si, where about 92 % of all naturally occurring silicon is ²⁸Si, about 5 % of all naturally occurring silicon is ²⁹Si, and about 2 % of all naturally occurring silicon is ³⁰Si. Although ²⁸Si is the most abundant isotope of silicon it is most prone to activation and therefore the least suitable isotope of silicon for use in a neutron translucent construction material. ³⁰Si is the best isotope in terms of neutron stability, but is naturally scarce. In the range of neutron bombardment relevant for the first wall of fusion reactors (about 10¹⁵ neutrons at 2.2 MeV per cm² per second) according to computer simulations ³⁰Si is the most neutron translucent and ²⁸Si second most neutron translucent natural occurring Si isotope.

The natural isotopes of tungsten are ¹⁸⁰W, ¹⁸²W, ¹⁸³W, ¹⁸⁴W, and ¹⁸⁶W, where less than 1 % of all naturally occurring tungsten is ¹⁸⁰W, about 27 % of all naturally occurring tungsten is ¹⁸²W, about 14 % of all naturally occurring tungsten is ¹⁸³W, about 31 % of all naturally occurring tungsten is ¹⁸⁴W, and about 28 % of all naturally occurring tungsten is ¹⁸⁶W.

Calculations with computer simulation program FISPACT [R.A. Forrest "FISPACT-2003 :User manual", UKAEA FUS 485,2002 and M.J. Moughlin and R.A.Forrest "Comprehensive activation calculations of reference materials for near term reactor concepts" Fusion Engineering and Design, 69 (2003) 711-717] indicate that for a first wall in a fusion reactor the burn-up of the naturally occurring isotopes ¹³C, ²⁹Si, ¹⁸³W is lowest of the elements C, Si and W respectively.

Some examples of suitable gas phase and/or volatile precursors for Si are Si(OMe)₄, Si(OEt)₄, SiH₄, SiF₄ and SiCl₄. Some examples of suitable gas phase precursors for W are WF₆, WCl₆ and W(CO)₆. Some examples of suitable gas phase precursors for Ti are Ti(OPr)₄, TiCl₄, TiBr, and TiI₄. Some examples of suitable gas phase and/or volatile precursors for C are CH₄, C₂H₆, C₂H₄, C₂H₂ C₃H₈, C₃H₆, C₃H₄, CO and CO₂. Some example of suitable gas phase or volatile precursurs of combinations of Si, W, C, Ti are Si(OCH₃)(CH₃), Si(CH₃)₄ and SiTi(OEt)y values of y range from 1 to 4.

Thereafter, the at least one precursor is enriched in at least one isotope in a gas phase isotope separation step. The precursor is enriched in at least one isotope of an element, wherein said at least one isotope has higher neutron resistance than another isotope of the same element. The neutron resistance of each isotope of a specific element can be theoretically determined.

The translucency of specific isotopes is assessed by computer simulation programs such as FISPACT [R.A. Forrest "FISPACT-2003 :User manual", UKAEA FUS 485,2002] to calculate the burn-up and resulting activation and gas evolution. The mechanical degradation of the materials is evaluated from the amount of gas evolution during activation. Details of the mechanical degradation of the materials are assessed by molecular dynamics computer programs [ R.H. Jones a.o. "Promise and challenges of SiCf/SiC composites for fusion energy applications", J. Nucl. Mat. 307-311, part2 (2002) 1057-1072].

Enriching the precursor in one or more isotopes can be accomplished by one or more methods selected from the group consisting of gas centrifuge separation, gaseous diffusion, filtration, magnetic field separation, and electrolysis. Preferably, the isotope enrichment comprises gas centrifuge separation. This technique allows the isotope enrichment of relatively heavy atoms (roughly at least atomic mass 20), which atoms are typically used in construction materials.

Relatively light atoms, such as lithium, can be efficiently isotope enriched using filtration technique.

According to the gas centrifuge technique a gaseous precursor feed stream can be fed through a pipe into the centre of the cylinder of the centrifuge, where it adopts a rotational motion. The centrifugal forces push the precursors with heavier isotopes closer to the wall of the rotor than the precursors with lighter isotopes. The gas closer to the wall becomes enriched in the precursors with heavier isotopes, whereas the gas nearer to the rotor axis becomes enriched in the precursors with lighter isotopes. Advantageously, the bottom of the rotating cylinder can be heated, producing convection currents that move the isotope enriched products up the cylinder, where they can be collected.

The enrichment level achieved by a single gas centrifuge is insufficient to obtain the desired concentration of specific isotope. It is therefore necessary to connect a number of centrifuges together, both in series and in parallel. This arrangement of centrifuges is known as a cascade. By repeating the above process over and over again in a centrifuge cascade, the desired level of enrichment can be achieved.

Preferably, the precursor is stable, at least chemically stable, under the conditions at which the isotope enrichment is employed. Decomposition of the precursor in the isotope enrichment step would be highly disadvantageous.

In an embodiment of the invention, therefore, the precursor is subjected to a chemical conversion prior to being fed to the respective isotope enrichment technique, which chemical conversion renders the precursor chemically stable under the conditions at which the respective isotope enrichment technique is employed.

In a further embodiment, which may be combined with the embodiment above, the isotope enriched product is subjected to a chemical conversion before being deposited on the substrate, which chemical conversion renders the isotope enriched product less chemically stable. Such a chemical destabilisation of the isotope enriched product can be advantageous for the deposition step. The isotope enriched product can for instance be activated for a specific deposition technique, such as chemical vapour deposition.

The isotope enriched product is then deposited on a substrate. Suitable deposition techniques include for instance chemical vapour deposition, physical vapour deposition, molecular beam epitaxy, and sol/gel dip coating.

Preferably, the isotope enriched product is deposited in the gas phase. This has the advantage that the equipment for deposition can be integrated with the isotope separation equipment. As a result, the process becomes less expensive. Off-gas from the deposition step can optionally be recycled to the gas centrifuge thus allowing the process to be carried out in a closed circuit. The off-gas may optionally be complemented with a fresh gas phase precursor stream.

In a specially preferred embodiment, the process of the invention comprises isotope enrichment using a gas centrifuge, preferably a cascade of multiple gas centrifuges, combined with a chemical vapour deposition technique. The temperature in the gas centrifuge and the deposition chamber can be different. Typically, the temperature in the deposition chamber is higher in order to effect decomposition of the isotope enriched product and deposition onto a substrate.

For specific deposition techniques, for instance in the case of chemical vapour deposition, it can be advantageous to add a reagent stream to the deposition chamber in order to effect or enhance the deposition onto the substrate. Possible reagent streams include oxygen, nitrogen, methane, and mixtures thereof.

In a further embodiment, the invention allows the deposition of multiple isotope enriched products onto the substrate by feeding the deposition chamber with more than one isotope enriched product. As an example a ³⁰Si enriched SiH₄ species can be co-deposited with a ¹³C enriched CH₄ species. It is also possible to deposit a first isotope enriched product onto the substrate and thereafter deposit a second isotope enriched product onto the substrate. Such a deposit sequence allows the provision of controlled layered structures.

The process of the invention yields a neutron shielding construction material provided on a substrate. Suitable substrates for carrying out the invention include C, SiC, W, and Mo. For construction purposes preferred substrates are C, SiC and W. The substrate may optionally be removed from the deposited product. The substrate may be removed by burning it away. In this case a substrate made of graphite is preferred.

In a further aspect the invention is directed to the neutron translucent construction material obtainable by the method of the invention. Such neutron translucent construction materials can comprise for example ²⁹Si, ³⁰Si, ²⁸SiC, and ²⁹SiC.

The inventors found that the construction material of the invention greatly transcends the prior art construction materials in terms of neutron translucency and accompany lifetime increase in a fusion reactor environment. For example ³⁰SiC is calculated to generate four times less gas (helium and hydrogen) than SiC resulting in an expected lifetime increase of ³⁰SiC of the same order compared to SiC materials without isotope tailoring.

After deposition of the isotope enriched product the coated substrate can be used for construction. In the alternative, the substrate can be removed after deposition of the isotope enriched product. The construction material can then be further processed for the purpose of construction according to conventional methods. The neutron shielding construction material can for instance be processed into a powder or into a coating on a substrate, which is different from the substrate on which the isotope enriched product is originally deposited.

The material of the invention can advantageously be applied in the construction of a nuclear reactor, preferably in the construction of the nuclear reactor wall. In particular, the construction material of the invention is suitable for construction of the so-called "first wall" of a nuclear reactor. This is the reactor wall that is in direct contact with the plasma. Another application for which the invention is particularly suitable is the construction of silicon carbide mirrors as well as tungsten mirrors.

Accordingly, in a further aspect the invention is directed to a nuclear reactor, comprising a neutron translucent construction material of the invention.

In yet a further aspect the invention is directed to the use of a neutron translucent construction material of the invention in the construction of a nuclear reactor, for instance for nuclear fission or nuclear fusion.

In a further aspect the invention is directed to the use of a neutron shielding construction material of the invention as a shielding material in military applications. The material can for instance be used in tanks and armour, for protection against neutron radiation.

## Claims

1. Process for preparing a neutron translucent construction material comprising
a) providing at least one gas phase precursor;
b) enriching the at least one precursor in at least one isotope of an element contained in said precursor in a gas phase isotope separation step, wherein said at least one isotope has higher neutron resistance than another isotope of the same element; and
c) depositing the isotope enriched product of step b) on a substrate.

2. Process according to claim 1, wherein step b) comprises isotope enrichment using one or more methods selected from the group consisting of gas centrifuge separation, gaseous diffusion, filtration, magnetic field separation, and electrolysis.

3. Process according to claim 1 or 2, wherein step b) comprises isotope enrichment using gas centrifuge separation.

4. Process according to claim 3, wherein said isotope enrichment using an gas centrifuge comprises a cascade of at least two gas centrifuges.

5. Process according to any one of the preceding claims, wherein step c) comprises one or more selected from the group consisting of chemical vapour deposition, physical vapour deposition, molecular beam epitaxy, and sol/gel dip coating.

6. Process according to any one of the preceding claims, wherein step c) comprises chemical vapour deposition.

7. Process according to any one of the preceding claims, wherein said at least one precursor comprises at least one element selected from the group consisting of C, Si, Ti, Li, W, Mo, Zr, Be, V, Cr, Cu, Ir, Ag, Dy, Hf and Ta.

8. Process according to any one of the preceding claims, wherein said at least one precursor is selected from the group consisting of Si(OMe)₄, Si(OEt)₄, SiH₄, SiF₄, SiCl₄, WF₆, WCl₆, W(CO)₆, CH₄, C₂H₆, C₂H₄, C₂H₂ C₃H₈, C₃H₆, C₃H₄, CO, CO₂, Si(OCH₃)(CH₃), Si(CH₃)₄and SiTi(OEt)_{y} values of y range from 1 to 4.

9. Process according to any one of the preceding claims, wherein step c) yields an off-gas, which off-gas is, optionally complemented with fresh gas phase precursor material, recycled as gas phase precursor in step a).

10. Process according to any one of the preceding claims, wherein step b) and step c) are performed at different temperatures, preferably step b) is performed at a lower temperature than step c).

11. Process according to any one of the preceding claims, further comprising a step prior to step b), wherein the precursor is subjected to a chemical conversion which stabilises the precursor.

12. Process according to any one of the preceding claims, further comprising a step between step b) and step c) wherein the product of step b) is subjected to a chemical conversion which destabilises the product of step b).

13. Process according to any one of the preceding claims, further comprising a step wherein said substrate is removed from the deposited product.

14. Neutron translucent construction material obtainable by a process according to any one of the preceding claims.

15. Neutron translucent construction material according to claim 14 in the form of a coating or powder.

16. Nuclear reactor comprising a neutron translucent construction material according to claim 14 or 15.

17. Use of a neutron shielding construction material according to claim 14 or 15 in the construction of a nuclear reactor, for instance for nuclear fission or nuclear fusion.
